# EUROPEAN PATENT APPLICATION

(11) **EP 2 615 627 A1**
(43) Date of publication of application: **17.07.2013**
(21) Application number: 12150753.7
(22) Date of filing: 11.01.2012
(51) Int. Cl.: H01L 21/02

(54) **Manufacturing method of composite poly-silicon substrate of solar cell**

(71) Applicant: Innovation & Infinity Global Corp., Hsinchu City (TW)
(72) Inventor: Chu, Chao-Cieh, 300 Hsinchu City (TW)
(74) Representative: Viering, Jentschura & Partner

(57) **Abstract**

A manufacturing method of a composite poly-silicon substrate of solar cells includes the following steps: providing a first substrate layer having a purity ranging from 2N to 3N; and forming a second substrate layer on the first substrate layer, where the purity of the second substrate layer ranges from 6N to 9N.

## Description

### BACKGROUND OF THE INVENTION

### 1. Field of the Invention

The instant disclosure relates to a manufacturing method of a silicon substrate; in particular, to a manufacturing method of a composite poly-silicon substrate of solar cells.

### 2. Description of Related Art

In recent years, photoelectric industry has been flourishing in Taiwan. For instance, Taiwan ranks among the top in the world in terms of the output value for semiconductors and LEDs. In addition, high-efficiency solar cells are under development locally in a rapid pace. A solar cell typically employs a semiconductor component to absorb light and convert into electrical energy. The absorbed light may be sunlight or artificial light. Taking a polymer solar cell as an example. When light falls on the cell, a polymer-based photoactive layer is used in the solar cell for absorbing light. The absorption of light, or photons, forms exciton electron-hole pairs. The electron and hole pairs are dissociated through the provision of an interface across which the chemical potential of electrons decreases. After exciton dissociation, the electron and hole are collected at contacts in creating current flow.

The more popular type of existing solar cells utilize crystalline bulk silicon, To produce a poly-silicon wafer, a wire saw is typically used to slice the silicon ingot into very thin (180 to 200 um in thickness) wafers. Prior to slicing, the molten silicon is doped with impurity atoms and turning it into a p-type extrinsic silicon. Each of the starting wafers is then diffused with n-type dopants on the surface thereof in forming a p-n junction a few hundred nanometers into the wafer surface.

However, the conventional poly-silicon wafers must have high purity to achieve ideal conversion efficiency for a PV cell. The silicon material has been purified several times before achieving a high purity condition. The purification process is costly and not environmental friendly. In addition, the structure of the solar cell actually performs the photoelectric conversion is the active layer. This active layer requires only a thickness ranging from 5 to 10 micrometers. Therefore, the unused portion of the high-purity substrate is thus wasted. Hence, how to reduce the manufacturing cost of solar cells while achieving high photoelectric conversion efficiency are eagerly being pursued today.

### SUMMARY OF THE INVENTION

The object of the instant disclosure is to provide a manufacturing method of a composite poly-silicon substrate of solar cells. The poly-silicon substrate manufactured in the instant disclosure is a composite substrate by forming a high purity silicon material on a lower purity while cheaper substrate to reduce cost effectively.

The instant embodiment of the instant disclosure provides a manufacturing method of a composite poly-silicon substrate of solar cells which comprises the following steps: providing a first substrate layer that has a purity which ranges from 2N to 3N; and forming a second substrate layer having a purity ranging from 6N to 9N on the first substrate layer.

The instant disclosure has the following advantages: the instant disclosure utilizes forming methods such as the semi-conducting method to form a high quality and high purity epitaxial layer or a high purity sputtered layer on a low purity substrate. The sputtered layer or the epitaxial layer is utilized as the active layer to reduce the consumption of high purity silicon, thereby replacing the traditional silicon bulks and reducing the total cost.

In order to further appreciate the characteristics and technical contents of the instant disclosure, references are hereunder made to the detailed descriptions and appended drawings in connection with the instant disclosure. However, the appended drawings are merely shown for exemplary purposes, rather than being used to restrict the scope of the instant disclosure.

### BRIEF DESCRIPTION OF THE DRAWINGS

Fig. 1 shows a schematic view of a first substrate layer in accordance with the instant disclosure;

Fig. 2 shows a schematic view of a composite poly-silicon substrate of solar cells in accordance with the instant disclosure;

Fig. 3 shows a schematic view of a solar cell in accordance with the instant disclosure;

Fig. 4 shows a flow chart of a manufacturing method of the composite poly-silicon substrate of solar cells in accordance with the instant disclosure.

### DETAILED DESCRIPTION OF THE PREFERRED EMBODIMENT

The instant disclosure provides a manufacturing method of a composite poly-silicon substrate of solar cells. The composite structure enables the reduction in consumption of high purity poly-silicon, thereby reducing the amount of high-purity poly-silicon used in a substrate and the production cost of the solar cells.

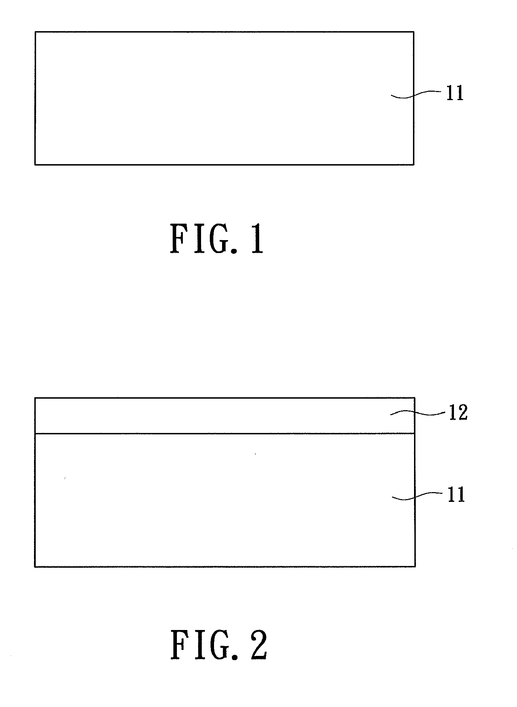

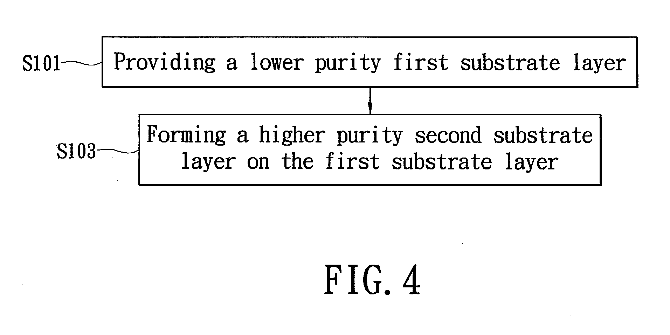

With reference to Figs. 4, 1, and 2, the manufacturing method of the composite poly-silicon substrate of solar cells includes the following steps:

Step S101: providing a first substrate layer 11. In the instant embodiment, the first substrate layer 11 is a lower purity silicon, for instance, the purity of the first substrate layer 11 ranges from 2N (99%) to 3N (99.9%). In other words, the first substrate layer 11 is an industrial-grade silicon which can be obtained easily at a low price. In the instant embodiment, the first substrate layer 11 is an industrial-grade silicon purchased from Yuxin Chemical of grade 411, 421, 553, 2202, and 3303 and so on. In addition, the thickness of the first substrate layer 11 ranges approximately from 160 µm to 180 µm.

Step S103: forming a second substrate layer 12 on the first substrate layer 11. The second substrate layer 12 of the instant disclosure is stacked on the first substrate layer 11. In comparison to the first substrate layer 11, the second substrate layer 12 is a high purity silicon, for instance, the purity of the second substrate layer 12 ranges from 6N (99.9999 %) to 9N (99.9999999 %). In addition, the thickness of the second substrate layer 12 ranges approximately from 5 µm to 20 µm. The aforementioned second substrate layer 12 mainly is a high purity silicon, which is also known as electronic grade silicon, and is generally utilized as the active layer in the solar cell. The thickness of the second substrate layer 12 is preferably smaller than the electron diffusion length to reduce the problem of the recombination of the electrons and the electron-holes due to the excessive thickness of the active layer, and also to reduce the consumption of the high purity silicon materials to save the material cost.

The second substrate layer 12 can form on the first substrate layer 11 by means of physical vapor deposition (PVD), chemical vapor deposition (CVD), liquid-phase epitaxy (LPE), etc., where the forming method is not restricted. Meanwhile, the methods of CVD and sputter deposition will be discussed in detail hereinbelow.

The CVD method directs the reactive source into the reaction chamber in the form of gas, where the source gas undergoes chemical reactions such as oxidation or reduction with the substrate, and the product is deposited on the substrate surface through diffusion, and other gaseous by-products are removed from the substrate surface. To be specific, the CVD procedure can be broken down into the following five main steps: (a) directing the reactive gas and diluting noble gas into the reaction chamber, wherein the gas mixture of the reactive gas and the noble gas is referred to as the mainstream; (b) the reactive gas atoms or molecules of the mainstream diffuse through the stagnant boundary layer to reach the substrate surface; (c) the reactive gas atoms are adsorbed on the substrate; (d) the absorbed atoms move on the substrate surface while producing surface chemical reactions necessary for the growth of the thin-film; (e) the gaseous by-products from the surface chemical reactions are dissociated and diffuse outward through the boundary layer and into the mainstream, and are eventually discharged by gas flow through the reaction chamber.

A doped silicon second substrate layer 12 is formed on the first substrate layer 11 by the instant embodiment. The source gas of the silicon atom can be dichlorosilane (SiH₂Cl₂), silane, trichlorosilane, or tetrachlorosilane. Diborane (B₂H₆) gas consisting of boron (B) may be used to obtain p-type silicon, while phosphine (PH₃) or arsine (AsH₃) gas can be used to obtain n-type silicon, with hydrogen being the carrier gas. Specifically, the mainstream of the instant embodiment includes dichlorosilane, diborane, and hydrogen. The mainstream is passed over the first substrate layer 11, where chemical reactions take place and last from 20 to 30 minutes under a temperature range 1000°C to 1100°C. The epitaxial second substrate layer 12 of p-Si (p-type silicon) may thus be grown.

Additionally, in concern with other manufacturing conditions, the flow rate of the dichlorosilane can range approximately from 200 to 300 sccm (standard cm³/min), while the flow rate of the diborane can range approximately from 5 to 10 sccm, and the flow rate of the hydrogen can range approximately from 80 to 100 sccm. The first substrate layer 11 can be heated up to 300°C to 350°C, and the working pressure can be adjusted within the range from 0.8 to 1 Torr.

Furthermore, the second substrate layer 12 can also be a sputtered layer, such as utilizing the sputter process to form a thin-film of silicon on the first substrate layer 11 through the pulsed DC magnetron sputtering technique. The manufacturing conditions include the working pressure ranging from 5 × 10⁻⁷ Torr to 9×10⁻⁷ Torr, the sputtering power which ranges from 100W to 300W, the support platform temperature which ranges from 200°C to 250°C, the deposition pressure being approximately 5 mTorr, and the sputtering gas (e.g., argon) having a flowrate that ranges from 8 to 10 sccm.

Furthermore, regarding the crystalline structure of the second substrate layer 12, which may turn out to be an amorphous layer after certain manufacturing process, a poly-crystallization process can be included. For example, laser crystallization can be used to turn the second substrate layer 12 into a poly-crystalline structure. Specifically, the amorphous second substrate layer 12 can utilize the excimer laser to increase its temperature up to approximately 1400°C within 20 ns of laser pulse, then condense to begin crystallization afterwards.

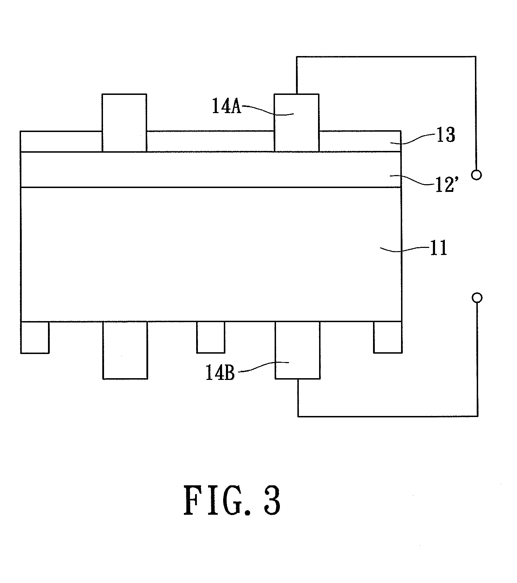

Referring to Fig. 3 which shows a schematic view of a solar cell having the poly-silicon substrate in accordance with the instant disclosure. The solar cell includes the first substrate layer 11, the second substrate layer 12, and electrodes 14A, 14B arranged on the poly-silicon substrate. Since the first substrate layer 11 is already described previously, therefore no further descriptions are provided herein. The second substrate layer 12 can be transformed into an n+-Si emitter layer 12' after the procedure of thermal diffusion of the phosphorous atoms or ion implantations. Preferably, the solar cell further includes an antireflection coating 13, such as silicon nitride, formed on the emitter layer 12'. The electrodes 14A can be made with titanium, palladium, gold, or any combination thereof and be arranged on the emitter layer 12'; while the electrodes 14B can be formed by coating a high conductivity metal such as the alumina gel and be arranged on the undersurface of the first substrate layer 11.

Based on the above, the instant disclosure has the following advantage. The formation of high purity silicon on a low purity silicon substrate replaces the typical expensive, high purity bulk substrate, thereby reducing the total cost dramatically. This composite poly-silicon substrate is applicable to solar cells to achieve a high efficiency and low cost epitaxial silicon solar cell.

The descriptions illustrated *supra* set forth simply the preferred embodiment of the instant disclosure; however, the characteristics of the instant disclosure are by no means restricted thereto. All changes, alternations, or modifications conveniently considered by those skilled in the art are deemed to be encompassed within the scope of the instant disclosure delineated by the following claims.

## Claims

1. A manufacturing method of a composite poly-silicon substrate of solar cells, comprising the steps of:
providing a first substrate layer (11) having a purity ranging from 2N to 3N; and
forming a second substrate layer (12) on the first substrate layer (11), wherein the purity of the second substrate layer ranges from 6N to 9N.

2. The manufacturing method of a composite poly-silicon substrate of solar cells according to claim 1, wherein for the step of providing the first substrate layer(11), the thickness of the first substrate layer (11) ranges from 160 um to 180 um.

3. The manufacturing method of a composite poly-silicon substrate of solar cells according to claim 2, wherein for the step of forming the second substrate layer (12), the thickness of the second substrate layer (12) ranges from 5 um to 20 um.

4. The manufacturing method of a composite poly-silicon substrate of solar cells according to claim 1, wherein for the step of forming the second substrate layer (12), the second substrate layer (12) is formed on the first substrate layer (11) by means of physical vapor deposition (PVD), chemical vapor deposition (CVD), liquid-phase epitaxy (LPE) or sputter deposition.

5. The manufacturing method of a composite poly-silicon substrate of solar cells according to claim 1, wherein for the step of forming a second substrate layer (12), chemical vapor deposition is used to provide a gas mixture of dichlorosilane, diborane, and hydrogen as a mainstream, and wherein the main stream passes over the first substrate layer (11) to begin the chemical vapor deposition process for 20 to 30 minutes under a temperature that ranges from 1000°C to 1100°C to form the p-type silicon second substrate layer (12).

6. The manufacturing method of a composite poly-silicon substrate of solar cells according to claim 5, wherein for the aforementioned CVD method, the flow rate of dichlorosilane ranges from 200 to 300 sccm, the flow rate of diborane ranges from 5 to 10 sccm, and the flow rate of hydrogen ranges from 80 to 100 sccm.

7. The manufacturing method of a composite poly-silicon substrate of solar cells according to claim 1, wherein for the step of forming the second substrate layer (12), the second substrate layer (12) is formed by the sputter deposition method.

8. The manufacturing method of a composite poly-silicon substrate of solar cells according to claim 7, wherein the sputter deposition method utilizes a pulsed DC magnetron sputtering device under the conditions with the working pressure ranging from 5×10⁻⁷ Torr to 9×10⁻⁷ Torr, the sputtering power ranging from 100W to 300W, the support platform temperature ranging from 200°C to 250°C, the deposition pressure at 5 mTorr, and the flowrate of argon (sputtering gas) ranging from 8 to 10 sccm, to form the second substrate layer (12).

9. The manufacturing method of a composite poly-silicon substrate of solar cells according to claim 1, wherein after the step of forming the second substrate layer (12) on the first substrate layer (11), further comprising a poly-crystallization step.

10. The manufacturing method of a composite poly-silicon substrate of solar cells according to claim 9, wherein the poly-crystallization step utilizes the laser crystallization method to transform the amorphous second substrate layer (12) into a poly-crystalline structure.
